# DEMANDE DE BREVET EUROPEEN

(11) **EP 4 766 129 A2**
(43) Date de publication de la demande: **24.06.2026**
(21) Numéro de dépôt: 25221983.7
(22) Date de dépôt: 09.12.2025
(51) Int. Cl.: H10P 50/24

(54) **PROCEDE DE GRAVURE PAR COUCHE ATOMIQUE DE MATERIAUX III-V**

(30) Priorité: 19.12.2024 FR 2414581
(71) Demandeur: Commissariat à l'Energie Atomique et aux Energies Alternatives, 75015 Paris (FR)
(72) Inventeur: CADOT, Stéphane, 38054 GRENOBLE CEDEX 09 (FR)
(74) Mandataire: Cabinet Beaumont

(57) **Abrégé**

La présente description concerne un procédé de gravure par ALE d'un matériau III-V comprenant les étapes suivantes :
a) placer dans une enceinte une structure comprenant une couche de matériau III-V (100),
b)mettre en œuvre, dans l'enceinte, à une température de gravure, une ou plusieurs fois le cycle ALE suivant :
- oxyder une surface de la couche de matériau III-V (100) avec un gaz oxydant, moyennant quoi une couche d'oxyde (110) est formée,
- purger l'enceinte sous flux de gaz inerte,
- exposer la couche d'oxyde (110) formée à une vapeur de chlorure de thionyle pour graver la couche d'oxyde (110),
- purger l'enceinte sous flux de gaz inerte.

## Description

### Domaine technique

La présente description concerne de façon générale le domaine de la microélectronique, et plus particulièrement les procédés de gravure de matériaux III-V. L'invention est particulièrement intéressante pour la fabrication de dispositifs de puissance ou de dispositifs optoélectroniques.

### Technique antérieure

Les matériaux III-V (GaN, InGaN, AlGaN, AlN, InN, GaAs, InGaAs, etc.) sont utilisés pour la fabrication de dispositifs optoélectroniques (micro-LEDs à haute brillance) ou de transistors de puissance (HEMT pour 'high electron mobility transistors').

Au cours du procédé de fabrication, ces matériaux sont gravés pour former des cavités ou motifs (trous de contacts dans le cas des transistors ou définition des pixels dans les cas des micro-LEDs). La gravure doit être rapide et directionnelle (anisotrope). Elle se base principalement sur l'utilisation de plasmas à base de BCl₃, Cl₂ ou d'un mélange de ces deux composés afin de former des composés volatils des métaux à graver (principalement GaCl₃, InCl₃ et AlCl₃). La formation de composés nécessite toutefois des énergies de plasma élevées, ce qui rend le procédé de gravure assez invasif et conduit à la formation de défauts de surface, voire d'une amorphisation de la surface du matériau III-V après gravure. Cette étape de gravure est généralement suivie d'un retrait de la résine de lithographie puis d'un nettoyage des résidus carbonés par calcination (plasma O₂). Cette étape peut également altérer le matériau III-V en surface (formation d'une couche d'oxyde).

La présence de ces défauts de surface est critique pour la performance des dispositifs précédemment citées. En effet, dans le cas d'un transistor de puissance, la présence de défauts liés à la gravure plasma, à l'oxydation de surface ou aux résidus de résine augmente la résistance de contact à l'interface métal/III-V dégradant ainsi les performances électriques du dispositif, et dans le cas des micro-LEDs, les défauts génèrent des recombinaisons de charges non radiatives au niveau des flancs des cavités entre les pixels, diminuant considérablement le rendement quantique de la LED.

Afin d'éliminer ces défauts, un nettoyage post-gravure peut être réalisé par voie humide (HCl ou solution tampon d'acide fluorhydrique (BOE)). Le nettoyage par voie humide conduit à l'obtention d'une surface propre et désoxydée. Cependant, un tel nettoyage doit être rapidement enchainé avec l'étape suivante pour éviter d'oxyder la surface nettoyée avant de déposer le métal de contact ou la couche de passivation.

Alternativement, le nettoyage post-gravure peut être réalisé par voie sèche, en utilisant un procédé de gravure par couches atomiques (ALE pour 'Atomic Layer Etching'). L'avantage de ce type de procédé est qu'il peut directement être réalisé dans un équipement de dépôt en phase vapeur, permettant ainsi d'enchainer (sans remise à l'air du dispositif) le nettoyage post-gravure et l'étape de dépôt.

Par exemple, le brevet US 8,124,505 B1 décrit un procédé de gravure par couches atomiques de GaN et d'autres matériaux III-V dans lequel le matériau est, dans un premier temps, oxydé en surface par un plasma O₂, puis la couche d'oxyde formée est gravée sélectivement par un plasma de BCl₃. A noter que les deux étapes du procédé nécessitent l'utilisation d'un plasma, ce qui n'est pas idéal pour l'obtention d'une surface dépourvue de défauts structurels

Le brevet US 10,056,264 B2 décrit un procédé alternatif de gravure par couches atomiques (ALE) de GaN et d'autres matériaux III-V basé sur l'utilisation d'un mélange BCl₃/Cl₂ pour chlorer la surface du matériau, suivi d'une vaporisation sélective de la couche chlorée par un plasma de gaz inerte. Cette méthode à l'inconvénient de terminer la séquence par un plasma pouvant générer des défauts structurels dans le matériau III-V.

L'article de Chittock et al. (« Isotropic atomic layer etching of GaN using SF6 plasma and Al(CH3)3 », J. Appl. Phys. (2023) 134, 075302) présente un procédé d'ALE de GaN basé sur l'alternance d'un plasma SF₆, et d'une exposition à une vapeur de triméthylaluminium (TMA). La surface du GaN est dans un premier temps fluorée par un plasma SF₆, puis le fluorure de surface est vaporisé en présence de TMA via une réaction d'échange qui permet de former des dérivés fluorométhyles volatils d'aluminium et de gallium (AlF(CH₃)₂ et GaF(CH₃)₂). Cette méthode peut être jugée plus douce que celles précédemment décrites dans la mesure où l'étape de gravure au TMA se fait chimiquement (sans plasma).

### Résumé de l'invention

Il existe un besoin d'avoir un procédé de gravure d'un matériau III-V remédiant aux inconvénients de l'art antérieur, et, en particulier, permettant une gravure isotrope du matériau III-V sans générer de défauts.

Ce but est atteint par un procédé de gravure par ALE d'un matériau III-V comprenant les étapes suivantes :
a) placer dans une enceinte une structure comprenant un substrat recouvert par une couche de matériau III-V,
b)mettre en œuvre, dans l'enceinte, à une température de gravure, une ou plusieurs fois le cycle de gravure de couches atomiques suivant :
   - oxyder une surface de la couche du matériau III-V avec un gaz oxydant, moyennant quoi une couche d'oxyde est formée,
   - purger l'enceinte sous flux de gaz inerte,
   - exposer la couche d'oxyde formée à une vapeur de chlorure de thionyle pour graver la couche d'oxyde,
   - purger l'enceinte sous flux de gaz inerte,
c) de préférence, déposer une couche d'intérêt sur la surface de la couche de matériau III-V gravée.

Selon un mode de réalisation particulier, le gaz oxydant est du dioxygène, de l'ozone ou du dioxyde d'azote.

Selon un mode de réalisation particulier, la température de gravure est comprise entre 20°C et 1000°C, de préférence entre 200°C et 600°C.

Selon un mode de réalisation particulier, le matériau III-V est dépourvu d'aluminium, le matériau III-V étant par exemple du GaN ou de l'InGaN, et la température de gravure est, de préférence, comprise entre 200°C et 400°C, encore plus préférentiellement entre 300°C et 400°C.

Selon un mode de réalisation particulier, le cycle comprend une injection de vapeur d'eau simultanément à l'injection de gaz oxydant ou après l'injection de gaz oxydant.

Selon un mode de réalisation particulier, le matériau III-V comprend de l'aluminium, le matériau III-V étant par exemple de l'AlGaN ou de l'AlN, et la température de gravure est, de préférence, comprise entre 300°C et 600°C, encore plus préférentiellement entre 400°C et 600°C.

Ce but est également atteint par un procédé de fabrication d'un dispositif de puissance par exemple un transistor, de préférence un transistor de type HEMT, comprenant un substrat recouvert par une couche en GaN et une ou plusieurs couches additionnelles en matériau III-V choisi parmi l'AlGaN et l'AlN, des trous traversants la ou les couches additionnelles et débouchant dans la couche de GaN, les trous traversants ayant été réalisés par une étape de gravure ionique réactive,
le procédé comprenant les étapes suivantes :
   a) placer le dispositif dans une enceinte,
   b)mettre en œuvre, dans l'enceinte à une température de gravure, de préférence, comprise entre 200°C et 600°C, une ou plusieurs fois le cycle d'étapes ALE suivant pour réaliser un nettoyage post-gravure :
      - exposer le dispositif à un gaz oxydant, moyennant quoi une couche d'oxyde est formée sur une surface de la couche de GaN exposée au gaz oxydant, une surface de la ou les couches additionnelles pouvant être également oxydée,
      - purger l'enceinte sous flux de gaz inerte,
      - exposer le dispositif à une vapeur de chlorure de thionyle pour graver la couche d'oxyde de la couche de GaN de manière sélective,
      - purger l'enceinte sous flux de gaz inerte,
   c) déposer dans les trous traversants une couche d'intérêt, notamment une couche métallique, par exemple en TiN, ou une couche en dichalcogénure, par exemple, en VS₂, la couche d'intérêt étant en contact avec la surface gravée de la couche de GaN,
l'étape c) étant réalisée dans l'enceinte utilisée lors de l'étape b).

Ce but est également atteint par un procédé de fabrication d'un dispositif optoélectronique, par exemple une micro-LED, comprenant un substrat recouvert par un empilement comprenant une couche de GaN dopée n, des puits quantiques par exemple en InGaN/GaN, une couche de GaN dopée p, et une couche d'oxyde transparent conducteur, l'empilement ayant été gravé, par gravure ionique réactive, de manière à former des pixels, la couche de GaN dopée n étant gravée partiellement, le procédé comprenant les étapes suivantes :
a) placer le dispositif dans une enceinte,
b)mettre en œuvre, dans l'enceinte à une température de gravure, de préférence, comprise entre 200°C et 600°C, une ou plusieurs fois le cycle d'étapes ALE suivant pour réaliser un nettoyage post-gravure :
   - exposer le dispositif à un gaz oxydant, moyennant quoi une surface de l'empilement exposée au gaz oxydant est oxydée et une couche d'oxyde est formée,
   - purger l'enceinte sous flux de gaz inerte,
   - exposer le dispositif à une vapeur de chlorure de thionyle pour graver la couche d'oxyde,
   - purger l'enceinte sous flux de gaz inerte,
c) déposer entre les pixels et sur le flanc des pixels, une couche diélectrique, par exemple en SiO₂, Al₂O₃, SiN ou AlN, l'étape c) étant réalisée dans l'enceinte utilisée lors de l'étape b).

Ce but est également atteint par un dispositif comprenant un substrat recouvert par une couche de matériau III-V, une couche d'intérêt, par exemple une couche de contact en métal, en dichalcogénure, ou une couche de passivation, par exemple en oxyde ou en nitrure, étant en contact avec la couche de matériau III-V, la surface de la couche de matériau III-V en contact avec la couche d'intérêt étant désoxydée.

Ce but est également atteint par un dispositif de puissance, par exemple un transistor, de préférence un transistor de type HEMT, comprenant un substrat recouvert par une couche en GaN et au moins une ou plusieurs couches additionnelles en matériau III-V choisi parmi l'AlGaN et l'AlN, des trous traversants la ou les couches additionnelles et débouchant dans la couche de GaN, une couche d'intérêt étant formée dans les trous traversants et en contact avec la couche de GaN, la couche d'intérêt étant une couche métallique, par exemple en TiN, ou une couche en dichalcogénure conducteur, par exemple en VS₂, la surface de la couche de GaN en contact avec la couche d'intérêt étant désoxydée.

Ce but est également atteint par un dispositif optoélectronique, par exemple une micro-LED, comprenant un substrat recouvert par un empilement comprenant une couche de GaN dopée n, des puits quantiques, une couche de GaN dopée p, et une couche d'oxyde transparent conducteur, l'empilement étant gravé de manière à former des pixels, la couche de GaN dopée n étant gravée partiellement,
une couche diélectrique recouvrant la couche de GaN dopée n entre les pixels et le flanc des pixels, la couche diélectrique étant en contact avec la couche de GaN dopée n, la couche diélectrique étant, par exemple, en SiO₂, Al₂O₃, SiN ou AlN,
la surface de la couche de GaN dopée n en contact avec la couche diélectrique étant désoxydée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

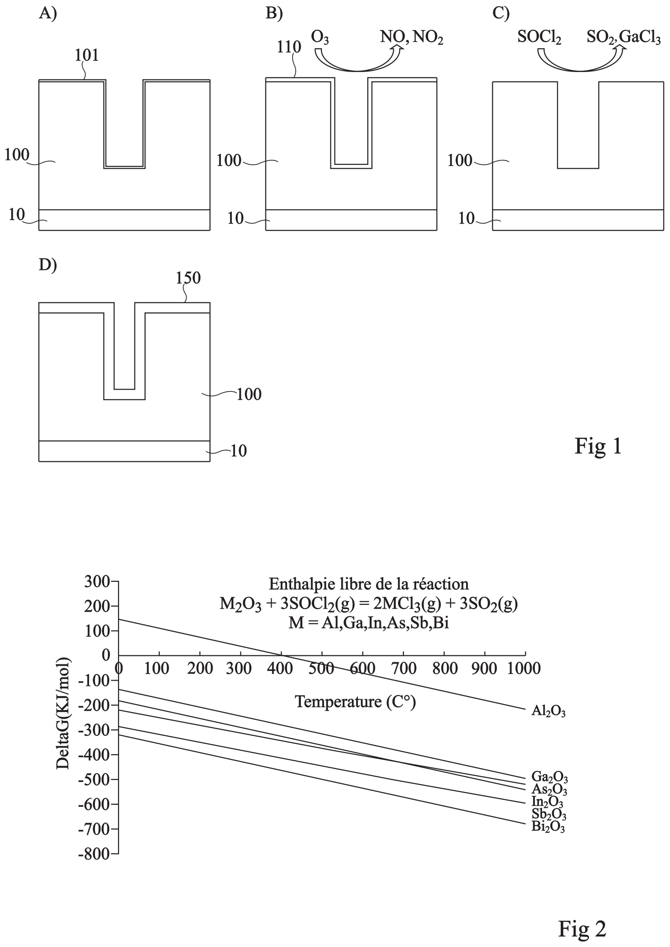

Les vues A), B), C) et D) de la figure 1 représentent, de manière schématique et en coupe, plusieurs étapes d'un procédé de gravure d'un matériau III-V, selon un mode de réalisation particulier de l'invention ;

la figure 2 est un graphique représentant les enthalpies libres de la réaction entre SOCl₂ et différents oxydes issus de l'oxydation de matériaux III-V ;

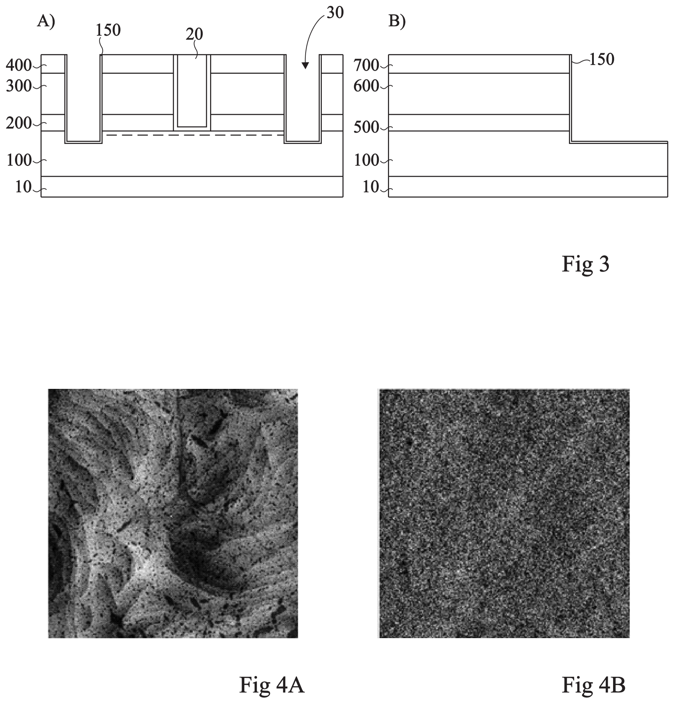

les vues A) et B) de la figure 3 représentent, respectivement, de manière schématique et en coupe, un transistor de puissance de type HEMT (les pointillés représentent le gaz d'électrons 2D) et une micro-LED selon différents modes de réalisation particuliers de l'invention ;

la figure 4A et la figure 4B sont des clichés obtenus au microscope à force atomique d'une couche de GaN, respectivement, avant et après un procédé de gravure de couches atomiques selon un autre mode de réalisation particulier (échelle 5µmx5µm).

Les différents éléments ne sont pas nécessairement représentés à une échelle uniforme pour rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par compris entre X et Y, on entend que les bornes X et Y sont incluses.

Le procédé qui va être décrit plus en détail par la suite, en faisant référence aux figures annexées, est un procédé purement thermique (c'est-à-dire sans plasma) de gravure par couches atomiques (ALE) de matériaux III-V. Il permet donc une gravure isotrope des matériaux III-V sans générer de défauts. Il est particulièrement adapté pour retirer les premiers nanomètres de surface qui ont été endommagés par le plasma lors de la gravure des motifs dans des dispositifs à base de matériaux III-V.

Le procédé comporte les étapes suivantes :
a) placer dans une enceinte une structure comprenant un substrat 10 recouvert par une couche de matériau III-V 100, le matériau III-V pouvant être recouvert par une couche d'oxyde natif 101 (vue A) de la figure 1),
b) mettre en œuvre, dans l'enceinte, à une température de gravure, de préférence comprise entre 20°C et 1200°C, encore plus préférentiellement entre 20°C et 1000°C et de manière encore plus préférentielle entre 200°C et 1000°C, une ou plusieurs fois un cycle de gravure de couches atomiques (ou ALE pour « Atomic Layer Etching »), moyennant quoi la surface de la couche de matériau III-V 100 est gravée (vues B) et C) de la figure 1),
c) de préférence, déposer une couche d'intérêt 150 (par exemple une couche de contact ou de passivation) sur la surface gravée (vue D) de la figure 1).

Le cycle ALE (ou séquence ALE) consiste à répéter les étapes suivantes de manière cyclique :
1) Exposition de la surface du matériau III-V 100 à un gaz oxydant (vue B) de la figure 1), moyennant quoi on forme une surface oxydée 110,
2) Purge du réacteur sous flux de gaz inerte,
3) Exposition de l'oxyde 110 du matériau III-V à une vapeur de chlorure de thionyle (vue C) de la figure 1),
4) Purge du réacteur sous flux de gaz inerte.

La répétition des étape 1) à 4) constitue un cycle ALE. La vitesse de gravure du matériau III-V est exprimée en nm/cycle ou Å/cycle et correspond à l'épaisseur moyenne de matériau III-V gravée pour chaque cycle ALE (moyenne sur plusieurs cycles). Les étapes 1) à 4) sont répétées jusqu'à retirer l'épaisseur désirée.

Le procédé met en œuvre une première étape d'oxydation de surface du matériau III-V afin de former une fine couche d'oxyde 110, puis une seconde étape au cours de laquelle la couche d'oxyde est gravée (volatilisée) de manière sélective en utilisant une vapeur de chlorure de thionyle (SOCl₂). Par gravée de manière sélective, on entend que seule la couche d'oxyde est gravée. Lors de cette étape, le matériau III-V n'est pas gravé. Seuls les quelques nanomètres de surface qui ont été endommagés et/ou oxydés sont retirés. La surface du matériau III-V est ainsi nettoyée et désoxydée.

L'étape d'oxydation 1) est limitée par la diffusion du gaz oxydant et reste très superficielle à la température utilisée pour le procédé. Lors de cette étape les éléments du groupe VA sont oxydés et éliminés pour les plus volatils d'entre eux (sous forme de NO, NO₂, P₄O₆, P₂O₅,..., ou gravés lors de l'étape 3) pour les moins volatils (As₂O₃, Sb₂O₃, Bi₂O₃).

L'étape de gravure 3) grave sélectivement l'oxyde formé lors de l'étape 1) via la formation de chlorures volatils d'éléments du groupe IIIA ou VA (GaCl₃, InCl₃, AlCl₃, AsCl₃, SbCl₃, BiCl₃), et l'élimination de l'oxygène sous forme de dioxyde de soufre (SO₂).

L'équation chimique de la réaction de gravure est la suivante : M₂O₃ + 3 SOCl₂(g) → 2 MCl₃(g) + 3 SO₂(g) (avec M l'élément métallique ou pnictogène).

Le chlorure de thionyle ne grave pas (ou très faiblement) les matériaux III-V. Il réagit de manière sélective avec les oxydes, ce qui permet de réaliser une gravure couche atomique par couche atomique dans laquelle chaque étape (oxydation et gravure) se limite aux atomes de surface du matériau.

Le gaz oxydant utilisé lors de l'étape 1) peut être de l'oxygène (O₂), de l'ozone (O₃), du dioxyde d'azote (NO₂) ou tout autre composé pouvant libérer de l'oxygène moléculaire ou radicalaire à la température du procédé. Le gaz oxydant peut être introduit dans le réacteur pur ou dilué dans un gaz inerte.

Il est possible d'injecter de l'eau sous forme de vapeur simultanément à l'injection de gaz oxydant ou consécutivement à l'injection de gaz oxydant.

Le temps d'exposition du matériau III-V au gaz oxydant est ajusté en fonction de la température du procédé de manière à garantir une oxydation autolimitée (c'est-à-dire que la couche d'oxyde formée à l'issue de l'étape 1) est suffisamment épaisse pour servir de barrière de diffusion au gaz oxydant, stoppant ainsi le processus d'oxydation). Ceci garantit une épaisseur identique de la couche d'oxyde en tout point de la surface du matériau.

L'épaisseur de la couche oxydée est typiquement inférieure à 5nm. Dans certains cas l'oxydation pourra être limitée aux seuls atomes exposés à la surface de l'échantillon (cas où le matériau III-V constitue lui-même une barrière de diffusion au gaz oxydant).

Le gaz de gravure (vapeur de SOCl₂) introduit lors de l'étape 3) est généré par évaporation d'une source liquide de SOCl₂. Le transport de masse est assuré soit par le différentiel entre la pression du réacteur et celle de la source de SOCl₂, soit par un flux de gaz inerte. Alternativement, le chlorure de thionyle peut être introduit dans le réacteur par injection directe. Le temps d'exposition à la vapeur de SOCl₂ du matériau à graver est ajusté afin de permettre idéalement la gravure totale de l'oxyde formé lors de l'étape 1) d'oxydation. Cette gravure totale de la couche d'oxyde assure une bonne uniformité du procédé et permet l'obtention d'une surface de matériau III-V totalement désoxydée à l'issue du procédé de gravure par ALE. Elle est facilitée par la capacité du chlorure de thionyle à réagir de manière sélective avec les oxydes.

Selon une variante de réalisation, le cycle ALE comprend des étapes ultérieures au cours desquelles les étapes 3) et 4) sont répétées une nouvelle fois.

Plusieurs expositions à SOCl₂ peuvent permettre de garantir l'élimination totale de l'oxyde formé lors de l'étape d'oxydation.

Les étapes d'oxydation 1) et de gravure 3) sont séparées par des purges permettant d'éliminer les sous-produits de réaction (oxydes volatils lors de l'étape d'oxydation, et chlorures volatils lors de l'étape de gravure) et d'éviter un mélange entre les deux précurseurs. Cette purge consiste à introduire un flux de gaz inerte ou maintenir le réacteur sous vide dynamique pendant un temps suffisamment long pour permettre l'évacuation totale des précurseurs et sous-produits de réaction gazeux introduits ou générés lors de l'étape précédente.

Les étapes de purges sont indispensables pour éviter le mélange des différents précurseurs. Dans le cas où les précurseurs seraient mélangés dans le réacteur, la gravure se ferait de manière continue (gravure de l'oxyde au fur et à mesure qu'il est généré). Dans le cas où le gaz oxydant et le chlorure de thionyle sont introduits de manière séquentielle et non mélangées, on obtient une excellente uniformité et un contrôle à l'échelle atomique de la gravure.

Le gaz neutre utilisé lors de l'étape 2) peut être identique au gaz neutre utilisé lors de l'étape 4). De préférence, les gaz sont identiques. Les gaz peuvent être choisis parmi l'azote, ou un gaz noble tel que l'hélium ou l'argon.

Le gaz neutre peut être utilisé comme gaz porteur (ou gaz de dilution) des espèces réactives utilisées lors des étapes d'oxydation (étape 1)) ou de gravure (étape 3)).

Nous allons maintenant décrire plus en détail les différentes étapes du procédé.

Avant l'étape a), la chambre de dépôt peut être passivée, par exemple, par un dépôt de SiO₂, d'alumine ou d'oxyde mixte d'aluminium et de silicium (AlSiOₓ) afin de protéger les éléments métalliques du réacteur de la corrosion par le SOCl₂.

La structure fournie à l'étape a) comprend un substrat 10 recouvert par une couche en matériau III-V 100 et éventuellement par une ou plusieurs couches additionnelles 200, 300, 400, 500, 600, 700. La ou les couches additionnelles peuvent être en un matériau III-V identique ou différent du matériau III-V de la couche 100.

Les matériaux III-V peuvent contenir de l'aluminium ou être dépourvu d'aluminium. Les matériaux III-V sont, par exemple, choisis parmi le GaN, l'InGaN, l'AlGaN, l'AlN, l'InN, le GaAs et le InGaAs. Les matériaux III-V peuvent être dopés ou non dopés.

Des motifs peuvent être formés dans la structure, par exemple pour délimiter des pixels ou créer des trous permettant la prise de contact sur les flancs du matériau III-V.

La structuration peut, par exemple, résulter d'une étape de gravure ionique réactive (ou RIE pour 'Reactive Ion Etching'). Les gaz utilisés pour la gravure sont, notamment, des gaz chlorés.

La couche de matériau III-V 100 peut être recouverte par une couche d'oxyde natif 101. Cette couche disparaitra lors de la mise en œuvre de l'étape b).

Le substrat 10 est, par exemple, en silicium ou en aluminium. Le substrat peut être passivé lors de l'étape 1).

L'étape a) est une étape de thermalisation du matériau à la température du procédé. La température à laquelle est chauffée le substrat lors de l'étape a) est, de préférence, identique à la température de l'étape b) et identique à la température lors de l'étape c).

La température du substrat lors de l'étape b) dépend du matériau à graver (figure 2). Elle est, de préférence, supérieure à 20°C. Elle peut être comprise entre 20°C et 1200°C, de préférence entre 200°C et 1000°C, et encore plus préférentiellement entre 200°C et 600°C. De préférence, elle est comprise entre 200°C et 400°C, encore plus préférentiellement entre 300 et 400°C, pour les matériaux III-V ne contenant pas d'aluminium (par exemple GaN, InGaN). De préférence, elle est supérieure à 300°C (par exemple entre 300°C et 600°C) et encore plus préférentiellement supérieure à 400°C (par exemple entre 400°C et 1000°C ou entre 400°C et 600°C) pour ceux contenant de l'aluminium (par exemple AlN, AlGaN).

Ainsi, à une température inférieure à 400°C, par exemple à 350°C, il sera par exemple possible de graver sélectivement du GaN ou de l'InGaN par rapport à de l'AlN ou de l'AlGaN. Ceci est particulièrement avantageux dans le cas d'une structure comprenant une couche en un matériau III-V 100 dépourvu d'aluminium et une ou plusieurs couches additionnelles 200, 300 en matériau III-V comprenant de l'aluminium (vue B) de la figure 3). La mise en œuvre de l'étape b) à une température inférieure à 400°C conduit à la gravure sélective du matériau III-V 100 dépourvu d'aluminium. La ou les couches additionnelles 200, 300 comprenant de l'aluminium ne sont pas gravées. Comme nous le verrons par la suite, cette gravure sélective est particulièrement intéressante pour fabriquer des dispositifs microélectroniques.

De préférence, la température lors de la gravure (étape b)) est identique à la température de dépôt (étape c)) qui va suivre. Par exemple, la température lors des étapes b) et c) est comprise entre 300°C et 400°C, pour les matériaux III-V dépourvu d'aluminium, ce qui est idéal pour l'enchainement avec un procédé de dépôt par CVD ou ALD de la plupart des métaux ou diélectriques usuels (SiO₂, SiN, Al₂O₃, AlN, HfO₂, TiN, Ti(Al)C, etc...).

Lors de l'étape b), la pression de travail est comprise, par exemple, entre 0,1Pa et 1000hPa, de préférence entre 0,1hPa et 50hPa.

Lors de l'étape c), une couche d'intérêt 150 (couche conductrice ou couche diélectrique) est déposée sur la surface gravée.

Les étapes b) et c) peuvent être réalisée dans la même enceinte, sans remettre le matériau en contact avec l'air avant le dépôt, afin d'éviter la présence d'oxyde à l'interface. Pour certains matériaux, cela permet de former une interface dite de van der Waals (dépourvue de liaisons covalentes) et donc de ne pas altérer l'état de surface du matériau III-V lors de la formation de la couche d'intérêt 150.

La surface des matériaux III-V ainsi gravée, et en contact avec la couche d'intérêt, est désoxydée (i.e. dépourvue d'oxygène).

La couche d'intérêt 150 peut être une électrode métallique, par exemple, à base de TiN, TiC, Ti(Al)C, VN, VC, NbN, TaN, MoN, WN, Ni, Co, Pt, Ru. De tels métaux peuvent être déposés par ALD et utilisés en tant que contacts sur transistors à base de matériaux III-V (principalement GaN/AlGaN). Selon une autre variante de réalisation, la couche d'intérêt est une couche de dichalcogénures conducteurs tels que VS₂, VSe₂, NbS₂, NbSe₂, TaS₂, TiS₂. Ces métaux ou semi-métaux peuvent être particulièrement intéressants en tant que contact dans des transistors de puissance.

Selon une autre variante de réalisation, la couche d'intérêt 150 est en un matériau diélectrique tel que SiO₂, Al₂O₃, HfO₂, ZrO₂, SiN ou AlN. De tels matériaux diélectriques peuvent être déposés par ALD et utilisés en tant qu'isolant électrique sur des pixels à base de matériaux III/V, pour des applications micro-LED par exemple.

Pour former la couche diélectrique en SiO₂ ou Al₂O₃, il est également possible de déposer dans un premier temps une couche barrière de SiN ou d'AlN (de fine épaisseur, typiquement entre 1,5 et 2 nm), afin de protéger la surface du matériau III-V de l'oxydation. Le dépôt ultérieur de SiO₂ ou d'Al₂O₃ va partiellement oxyder cette couche barrière pour former une couche de passivation principalement constituée d'oxyde tout en préservant la surface du matériau III-V.

Les étapes a), b) et c) peuvent être directement implémentées dans la plupart des réacteurs de dépôt sous vide, ce qui permet d'enchainer sans remise à l'air la préparation de surface par ALE du matériau III-V et le dépôt de métal ou de diélectrique qui suit dans le processus de fabrication du dispositif.

En particulier, le cycle ALE est mis en œuvre dans un réacteur de dépôt en phase vapeur, idéalement de type ALD ('atomic layer déposition') ou CVD ('chemical vapor deposition'), de préférence modifié pour permettre l'envoi séquentiel des précurseurs.

Le caractère isotrope et autolimitant de l'ALE permet également d'implémenter le procédé dans des réacteurs de type 'batch' .

Le procédé de gravure précédemment décrit peut être mis en œuvre pour fabriquer un dispositif, par exemple un dispositif de puissance ou un dispositif optoélectronique, comprenant un substrat 10 recouvert par une première couche 100 en un premier matériau III-V et au moins une ou plusieurs couches additionnelles 200, 300, 500, 600 en matériau III-V identiques ou différents du matériau III-V de la première couche 100.

Le procédé peut comprendre les étapes suivantes :
a) placer le dispositif dans une enceinte,
b)mettre en œuvre une ou plusieurs fois le cycle d'étapes ALE suivant à une température de gravure :
   - exposer le dispositif à un gaz oxydant, moyennant quoi des couches d'oxyde sont formées sur les surfaces des matériaux III-V exposées au gaz oxydant,
   - purger l'enceinte sous flux de gaz inerte,
   - exposer le dispositif à une vapeur de chlorure de thionyle (SOCl₂) pour graver au moins la couche d'oxyde 110 formée sur le premier matériau III-V de la première couche 100,
   - purger l'enceinte sous flux de gaz inerte,
c) éventuellement, déposer une couche d'intérêt 150 au moins sur la surface du premier matériau III-V gravé.

Le procédé de gravure de couches atomiques est particulièrement pertinent pour diminuer la densité de défauts aux interfaces III-V/métal ou III-V/diélectrique au niveau des contacts (source et drain) dans les transistors de puissance notamment en GaN/AlGaN, (vue A) de la figure 3), ou pour les dispositifs optoélectroniques, notamment pour la passivation des flancs des pixels dans les micro-LEDs à base de GaN (vue B) de la figure 3).

A titre illustratif et non limitatif, le dispositif de puissance, notamment un transistor de puissance par exemple de type HEMT ('High Electron Mobility Transistors'), peut être fabriqué selon les étapes suivantes :
- fournir une structure comprenant successivement un substrat 10, une couche de GaN 100, un empilement formé d'une couche d'AlGaN 200, une couche d'AlN 300, une couche de SiN 400, une grille 20 étant formée dans l'empilement,
- graver l'empilement et une partie de la couche de GaN 100 pour former, de part et d'autre, de la grille 20 des trous de contact 30 pour les régions de source et de drain, l'étape de gravure étant de préférence réalisée par gravure ionique réactive,
- réaliser un nettoyage post-gravure en gravant sélectivement le GaN 100 selon le cycle ALE de l'étape b) précédemment décrit,
- déposer une couche de contact 150 dans les trous traversants, la couche de contact étant en contact avec la couche de GaN 100 et étant de préférence en métal ou en dichalcogénure conducteur(vue A) de la figure 3).

L'étape de nettoyage post-gravure et de dépôt sont, avantageusement, dans la même enceinte, sans remise à l'air de la structure. La surface de la couche de GaN 100 en contact avec la couche d'intérêt 150 est désoxydée.

A titre illustratif et non limitatif, le dispositif optoélectronique, notamment une micro-LED, peut être fabriqué selon les étapes suivantes :
- fournir une structure comprenant successivement un substrat 10, une couche de GaN dopée n 100, un empilement formé de puits quantiques (MQW) 500 en matériau III-V (par exemple des puits InGaN/GaN), une couche de p-GaN 600, une couche d'oxyde transparent conducteur 700 (par exemple de l'oxyde d'indium étain (ITO)),
- graver l'empilement et une partie de la couche de GaN dopée n 100 pour définir les flancs des pixels, l'étape de gravure étant de préférence réalisée par gravure ionique réactive,
- réaliser un nettoyage post-gravure en mettant en œuvre le cycle ALE de l'étape b) précédemment décrit, pour graver les couches en matériaux III-V,
- déposer une couche d'intérêt isolante 150 sur les flancs des pixels et sur la couche de GaN dopée n 100, la couche d'intérêt isolante 150 pouvant être un diélectrique tel que l'alumine, ou tout autre oxyde ou nitrure isolant (vue B) de la figure 3).

L'étape de nettoyage et de dépôt sont, avantageusement, dans la même enceinte, sans remise à l'air de la structure. La surface de la couche de GaN dopée n 100 en contact avec la couche diélectrique 150 est désoxydée.

Le procédé est, avantageusement, mis en œuvre, pour des dispositifs comprenant une électrode en aluminium. En particulier, il s'agit de l'électrode inférieure. En effet, dans la séquence de gravure par ALE, l'aluminium n'est pas gravé car l'oxydant va former une couche barrière d'Al₂O₃ et protéger l'électrode de la gravure au SOCl₂. La gravure étant sélective, les électrodes en aluminium sont préservées et l'intégration est facilitée. Il n'y a pas besoin d'utiliser des masques durs pour protéger l'électrode lors du procédé.

Avec le procédé précédemment décrit, le dispositif obtenu présente une très bonne qualité au niveau de l'interface entre le matériau III-V et la couche de passivation ou le métal de contact. Le matériau III-V est dépourvu d'oxyde en surface. De plus, en retirant la couche de surface qui a été endommagée, au moins une partie des défauts structurels formés lors de la gravure RIE est retirée, ce qui améliore les performances du dispositif final.

### Exemple illustratif et non limitatif

Dans cet exemple, une couche de GaN est gravée par ALE thermique.

Une couche mince de GaN épitaxiée sur silicium 111 est introduite dans un réacteur ALD équipé d'un générateur d'ozone et d'une source de SOCl2 maintenue à 20°C. La pression de travail est d'environ 1hPa avec un flux continu de 500ml/min d'azote. Le wafer est chauffé à une température de 350°C et exposé à 600 cycles de la séquence de gravure suivante :
- O₃ (19% dans O2) ; 200ml/min ; 12s
- Purge N₂ ; 500ml/min ; 15s
- SOCl₂(g) ; 1000ml/min ; 0.2s
- Purge N₂ ; 500ml/min ; 15s

Une mesure par ellipsométrie avant et après gravure indique que 6,7nm de GaN ont été gravés, soit une vitesse de gravure de 0.11Å/cycle. La même séquence utilisée sans l'étape d'oxydation (600 cycles de SOCl₂ seul) ne conduit à aucune gravure mesurable du GaN, ce qui confirme le régime ALE du procédé et la sélectivité totale de la gravure du Ga₂O₃ par SOCl₂ vis-à-vis du GaN à 350°C.

Une caractérisation a également été réalisée par AFM avant et après procédé ALE (figures 4A et 4B). Les clichés obtenus par AFM confirment que la couche de GaN après le procédé ALE est gravée de manière uniforme.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de gravure par ALE d'un matériau III-V comprenant les étapes suivantes :
a) placer dans une enceinte une structure comprenant un substrat (10) recouvert par une couche de matériau III-V (100),
b)mettre en œuvre, dans l'enceinte, à une température de gravure, une ou plusieurs fois le cycle de gravure de couches atomiques suivant :
- oxyder une surface de la couche du matériau III-V (100) avec un gaz oxydant, moyennant quoi une couche d'oxyde (110) est formée,
- purger l'enceinte sous flux de gaz inerte,
- exposer la couche d'oxyde (110) formée à une vapeur de chlorure de thionyle pour graver la couche d'oxyde (110),
- purger l'enceinte sous flux de gaz inerte, c) de préférence, déposer une couche d'intérêt (150) sur la surface de la couche de matériau III-V (100) gravée.

2. Procédé selon la revendication précédente, dans lequel le gaz oxydant est du dioxygène, de l'ozone ou du dioxyde d'azote.

3. Procédé selon l'une des revendications précédentes, dans lequel la température de gravure est comprise entre 20°C et 1000°C, de préférence entre 200°C et 600°C.

4. Procédé selon l'une des revendications 1 à 3, dans lequel le matériau III-V est dépourvu d'aluminium, le matériau III-V étant par exemple du GaN ou de l'InGaN, et dans lequel la température de gravure est, de préférence, comprise entre 200°C et 400°C, encore plus préférentiellement entre 300°C et 400°C.

5. Procédé selon la revendication précédente, dans lequel le cycle comprend une injection de vapeur d'eau simultanément à l'injection de gaz oxydant ou après l'injection de gaz oxydant.

6. Procédé selon l'une des revendications 1 à 3, dans lequel le matériau III-V (100) comprend de l'aluminium, le matériau III-V étant par exemple de l'AlGaN ou de l'AlN, et dans lequel la température de gravure est, de préférence, comprise entre 300°C et 600°C, encore plus préférentiellement entre 400°C et 600°C.

7. Procédé de fabrication d'un dispositif de puissance par exemple un transistor, de préférence un transistor de type HEMT, comprenant un substrat (10) recouvert par une couche en GaN (100) et une ou plusieurs couches additionnelles (200, 300) en matériau III-V choisi parmi l'AlGaN et l'AlN, des trous traversants la ou les couches additionnelles (200, 300) et débouchant dans la couche de GaN (100), les trous traversants ayant été réalisés par une étape de gravure ionique réactive,
le procédé comprenant les étapes suivantes :
a) placer le dispositif dans une enceinte,
b)mettre en œuvre, dans l'enceinte à une température de gravure, de préférence, comprise entre 200°C et 600°C, une ou plusieurs fois le cycle d'étapes ALE suivant pour réaliser un nettoyage post-gravure :
- exposer le dispositif à un gaz oxydant, moyennant quoi une couche d'oxyde (110) est formée sur une surface de la couche de GaN (100) exposée au gaz oxydant, une surface de la ou les couches additionnelles (200, 300) pouvant être également oxydée,
- purger l'enceinte sous flux de gaz inerte,
- exposer le dispositif à une vapeur de chlorure de thionyle (SOCl₂) pour graver la couche d'oxyde (110) de la couche de GaN (100) de manière sélective,
- purger l'enceinte sous flux de gaz inerte,
c) déposer dans les trous traversants une couche d'intérêt (150), notamment une couche métallique, par exemple en TiN, ou une couche en dichalcogénure, par exemple, en VS₂, la couche d'intérêt (150) étant en contact avec la surface gravée de la couche de GaN (100),
l'étape c) étant réalisée dans l'enceinte utilisée lors de l'étape b).

8. Procédé de fabrication d'un dispositif optoélectronique, par exemple une micro-LED, comprenant un substrat (10) recouvert par un empilement comprenant une couche de GaN dopée n (100), des puits quantiques (500) par exemple en InGaN/GaN, une couche de GaN dopée p (600), et une couche d'oxyde transparent conducteur (700), l'empilement ayant été gravé, par gravure ionique réactive, de manière à former des pixels, la couche de GaN dopée n (100) étant gravée partiellement,
le procédé comprenant les étapes suivantes :
a) placer le dispositif dans une enceinte,
b)mettre en œuvre, dans l'enceinte à une température de gravure, de préférence, comprise entre 200°C et 600°C, une ou plusieurs fois le cycle d'étapes ALE suivant pour réaliser un nettoyage post-gravure :
- exposer le dispositif à un gaz oxydant, moyennant quoi une surface de l'empilement exposée au gaz oxydant est oxydée et une couche d'oxyde (110) est formée,
- purger l'enceinte sous flux de gaz inerte,
- exposer le dispositif à une vapeur de chlorure de thionyle (SOCl₂) pour graver la couche d'oxyde (110),
- purger l'enceinte sous flux de gaz inerte,
c) déposer entre les pixels et sur le flanc des pixels, une couche diélectrique, par exemple en SiO₂, Al₂O₃, SiN ou AlN, l'étape c) étant réalisée dans l'enceinte utilisée lors de l'étape b).
